**Europäisches Patentamt**

**European Patent Office**

**Office européen des brevets**

(11) Publication number: **0 055 811**
**B1**

## (12) EUROPEAN PATENT SPECIFICATION

(45) Date of publication of patent specification: **27.01.88**

(51) Int. Cl.⁴: **H 05 K 13/04**

(21) Application number: **81108980.4**

(22) Date of filing: **27.10.81**

(54) **Pinned substrate and method for pinning a substrate.**

(30) Priority: **07.01.81 US 223190**

(43) Date of publication of application:
**14.07.82 Bulletin 82/28**

(45) Publication of the grant of the patent:
**27.01.88 Bulletin 88/04**

(84) Designated Contracting States:
**DE FR GB IT**

(56) References cited:

IBM TECHNICAL DISCLOSURE BULLETIN, vol.
9, no. 4, September 1966, page 365, New York,
USA; H.P. BYRNES: "Terminal pin projector"

IBM TECHNICAL DISCLOSURE BULLETIN, vol.
22, no. 8B, January 1980, pages 3649-3650,
New York; USA; R.J. MODLO et al.: "Low-
stress pin insertion"

IBM TECHNICAL DISCLOSURE BULLETIN, vol.
14, no. 1, June 1971, pages 174-175, New York,
USA; J.R. LYNCH: "Pinning technique for
ceramic module"

(73) Proprietor: **International Business Machines
Corporation
Old Orchard Road
Armonk, N.Y. 10504 (US)**

(72) Inventor: **Houser, David Erle
9 Crescent Drive
Apalachin N.Y. 13732 (US)**

(74) Representative: **Barth, Carl Otto et al
IBM Deutschland GmbH Patentabteilung
Schönaicher Strasse 220
D-7030 Böblingen (DE)**

Courier Press, Leamington Spa, England.

## Description

The invention relates to pinned ceramic substrates as known e.g. from the document IBM Technical Disclosure Bulletin Vol. 22, No 8B, January 1980, pages 3649—3650, "Low-stress pin insertion", R. J. Modlo et al. As is well known to those skilled in the electronic packaging art, substrates are used in a variety of systems such as printed wiring, microelectronic and/or hybrid systems, to name just a few.

It is often desirous to affix a metallic member in an opening of the substrate. By way of example, in U.S. Patent No. 3 484 937, an interface pin which electrically interconnects two printed circuit conductors carried on opposite sides of a printed circuit board, is inserted through a preformed hole of the board's substrate, which is made of impregnated fiberglass cloth or other suitable material. The pin is initially inserted in the hole as a blank of soft copper that has a diameter slightly less than that of the hole. The ends of the pin blank are contained to limit radial expansion while the pin is longitudinally compressed. This causes an expansion of its center portion radially outward into firm interengagement with the walls of the hole. The extent of the longitudinal compression and radial expansion of the pin is dependent upon the particular board material being used, but is made such that the mechanical interconnection between pin and board is of adequate strength to assure retention of the pin properly positioned in the hole through subsequent assembly and until solder is subsequently applied to the exposed pin ends.

Substrates of ceramic material are not suitable for affixing pins in the substrate's holes to the substrate using the principles of the last mentioned prior art system. Ceramic substrates are rigid and brittle. Thus, they easily are damaged by cracking, chipping and the like by the forces created by the expanded center portion of the copper pin as it physically pushes against the walls of the hole.

In another prior art system, such as the one described in United States Patent No. 3 566 464, pins are driven into preformed substrate holes, which are of somewhat smaller cross-section than the pins, so as to establish a tight press or wedge fit. Likewise, these prior art systems are not suitable for pinning substrates of ceramic material. The force of the copper pin as its end physically pushes against the rim of the substrate surrounding the smaller diameter hole readily cracks and damages the ceramic substrate.

There are also prior art systems in which the pins are driven or propelled at high velocities so that the pin provides its own opening either partially or completely through the body of the substrate. Two such prior art systems are described in Canadian Patent 891 180, issued 18 January, 1972 and the publication entitled "Terminal Pin Projector", H. P. Byrne, IBM Technical Disclosure Bulletin, Vol. 9, No. 4, 1966, page 365. However, these prior art system types are also not conducive for pinning ceramic substrates as the striking force-propelled pins would crack and hence damage the ceramic substrate.

None of the aforementioned prior art systems are satisfactory for producing reliable mechanical interconnections between a ceramic substrate and a metallic pin in the hole of the substrate. In these prior art systems, the pin remains in a solid or plastic state when being affixed, i.e., compressed, squeezed, inserted, and/or driven as the case might be. The pin is thus physically obstructed by the rigid but brittle ceramic substrate when it comes in contact with the substrate resulting in damage to the substrate because of cracking or the like.

To overcome this difficulty, a prior art system known and referred to herein as a head and bulge system is commonly used to pin ceramic substrates. Essentially, a pin blank is inserted in a larger diameter preformed hole of the substrate such that it protrudes outwardly on each side of the substrate. A head is formed on the protrusion of the pin on one side of the substrate and a bulge is formed in the protrusion of the pin on the other side of the substrate. As such, the substrate surrounding the hole and lying under the head and under the bulge becomes tightly wedged therebetween thus affixing or securing the pin to the substrate per se or in combination with the type of mechanical press fit, e.g., snug fit, frictional fit, tight fit, medium-force fit, or heavy-force fit, effected between the pin and substrate hole wall. Examples of such prior art systems are described in U.S. Patent Nos. 3 216 097; 3 257 708; and 3 768 134. However, even these prior art systems are not entirely satisfactory, because the pin remains in its solid or plastic state during the head and bulge forming operations. As a result, the ceramic is often chipped, crushed, cracked and/or otherwise damaged by the pins during these operations. While, prior art systems such as, for example, the ones described in U.S. Patent No. 3 735 466 and the publication entitled "Low-Stress Pin Insertion", R. J. Modlo et al., IBM Technical Disclosure Bulletin, Vol. 22, No. 8B, January 1980, pages 3649—3650, mitigate to some extent the damage to the ceramic substrates caused by such operations, they too are not entirely satisfactory because the pins still remain in a solid or plastic state during these operations and can thus cause damage to the ceramic substrate.

In certain prior art systems of the pinned ceramic substrate types, a headless pin is press fit into the hole of the substrate and an end of the pin is solder bonded to a conductive line carried on the appropriate metallized surface of the ceramic surface. A bulge may or may not be formed in the pin. The devices of U.S. Patent Nos. 4 082 394 and 4 092 697 are examples of each of these prior art systems. However, because the pin remains in its solid or plastic state as it is being press fit into the substrate hole and/or during the bulge forming operation, it can effect damage to the ceramic substrate.

Moreover, all of the prior art systems described heretofore are conducive to producing an undesirable space or void between the substrate hole wall and the pin which weakens the effectiveness of the interconnection between the pin and the substrate. In addition, this space becomes a repository for undesirable contaminants which further weaken the mechanical connection between the pin and the ceramic substrate and/or the electrical integrity of the pin itself when used as an electrical connector.

There are two other prior art systems that are related to pinned ceramic substrates. The first is described in U.S. Patent No. 3 737 651. In this system, the pins are provided with heads and are inverted such that the tops of the heads are solder bonded to metallic contact pads carried on an appropriate metallized surface of the ceramic substrate. As such, the pins are not located within any hole in the substrate, but are completely externally mounted to the board. The interconnection is thus merely limited to the solder bond between the pin head and the pad and hence is not as reliable or as mechanically stable as in the systems where the pin is located in a substrate hole.

The second pinned ceramic substrate system is described in the publication entitled "Pinning Technique for Ceramic Module", J. R. Lynch, IBM Technical Disclosure Bulletin, Vol. 14, No. 1, June 1971, pages 174—175. It uses a shrink-fit like principle to affix the pins thereof in the holes of a ceramic substrate. To do this, the ceramic substrate must be provided in pressed unfired, i.e., uncured, form with preformed holes. Copper pin blanks of smaller diameter are inserted into the substrate holes. The blanks extend on through the substrate holes and into correspondingly aligned holes of a graphite mold and locating fixture which supports the blank-loaded substrate and is used to cast the pins as a result of the blanks being melted in the subsequent firing cycle of the ceramic substrate.

The assembly when it is run through the ceramic firing cycle melts the copper blanks as aforementioned and cures the ceramic. After the copper solidifies, the firing shrinkage associated with the ceramic substrate causes the ceramic to shrink around the copper resulting in a pinned part which has the cast pin locked into the ceramic, but not into the graphite mold because of the different coefficients of expansion of the copper and graphite. Again, in this system because the copper is required to return to its solid or plastic state before the ceramic can effectively shrink around it, the ceramic substrate is subject to damage as it contracts around the copper. Moreover, the associated process requires precise control and a positive belt furnace and hydrogen atmosphere for both the firing and casting. Because of its fabrication complexity, the aforedescribed pinned ceramic substrates are not conducive to being fabricated in a simple and reliable manner and on a mass production basis.

An object of this invention is to provide a ceramic substrate with an improved mechanical and/or electrical interconnection between the ceramic substrate and a metallic member having at least a portion within an opening of the substrate.

Another object of this invention is to provide a pinned ceramic substrate that mitigates damage to the substrate when effecting the aforementioned interconnection.

These objects are met by the characterizing features of the claims 1 and 5.

According to the invention, the substrate includes solid member means having at least one opening in a predetermined region. The solid member means at least within the predetermined region is comprised of ceramic particles. Metallic members are also included. The metallic member has at least a portion located in the opening. The portion has an extension in interlocking engaged relationship with the ceramic particles of the predetermined region. The extension is formed by a predetermined impact force applied to the metallic member that places the metallic member in a temporary viscoelastic fluid state causing a partial flow thereof between the ceramic particles, the extension and interlocking engaged relationship with the ceramic particle being effected upon return of the metallic member and the fluid flow thereof to its undisturbed solid state.

Features and advantages of the invention will be apparent from the more particular description of a preferred embodiment of the invention, as illustrated in the accompanying drawing, in which:

FIG. 1 is a cross-sectional view of a preferred embodiment of the substrate of the present invention;

FIG. 1A is an enlarged partial cross-sectional view of the apparatus of Fig. 1, illustrating a pin in an opening of the substrate;

FIG. 1B is an enlarged cross-sectional view of a partial section of the extension of the pin of Fig. 1A illustrating in greater detail the interlocking engaged relationship with the ceramic substrate;

FIG. 2 is a perspective view, shown schematically, of a machine used to pin a ceramic substrate in accordance with the principles of the present invention;

FIG. 3 is a microphotograph of a cross-sectional portion of a ceramic substrate pinned in accordance with the principles of the present invention; and

FIG. 4 is a microphotograph of a cross-sectional portion of a ceramic substrate pinned using a prior art head and bulge system.

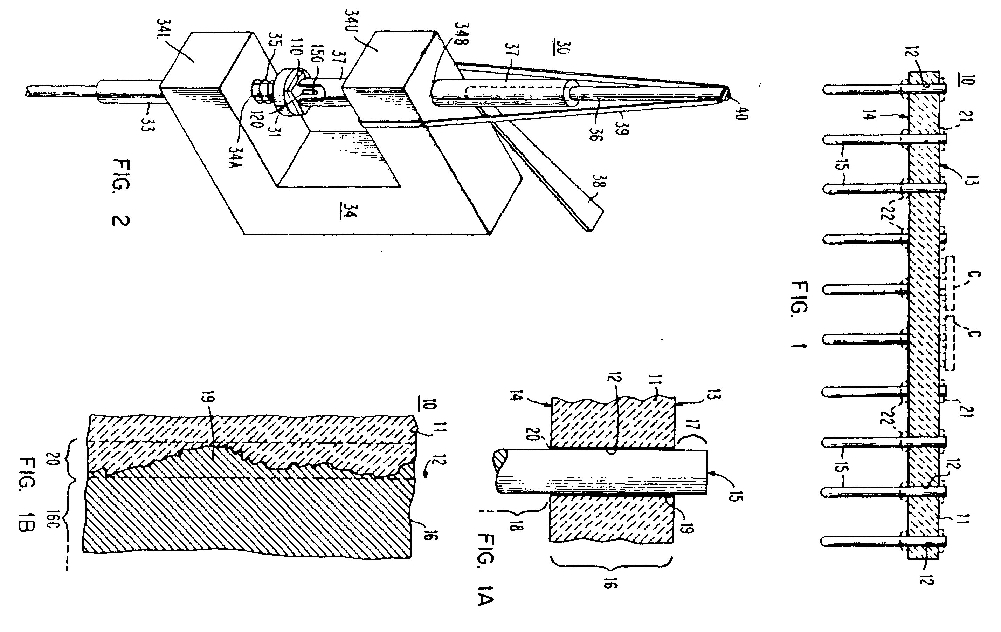

Referring to Figs. 1, 1A, 1B, the pinned substrate 10 of the preferred embodiment is intended for use as part of an integrated circuit package of the pluggable type. An example of such a package type is described in the aforementioned U.S. Patent No. 4 092 697. The pinned substrate 10 includes a rectangular ceramic substrate 11 which has a plurality of openings 12 arranged in a peripheral array. Formed on the upper surface 13 of substrate 11 is a metallized layer, not shown for sake of clarity. The metallized layer, it should be understood, includes circuit lines, i.e. conductors, bonding pads and lands. One or more integrated circuit devices or chips C are adapted to be mounted via their respective input/output terminals, not shown, to the bonding pads on the surface 13 of substrate 11 by a plurality of connections which may be, for example, solder balls.

Pinned substrate 10 includes a plurality of metallic members 15, each of which is a conductive pin preferably of copper. The openings 12 extend through both sides of substrate 11, i.e. through to both planar surfaces 13 and 14. Each pin 15 has an intermediate portion 16 within an opening 12 as shown in greater detail in Fig. 1A. Each pin 15 is an elongated member that has a smaller upper portion 17 which extends slightly above the surface 13 and a protruding longer portion 18 which extends below surface 14 and which is the part adapted to be received or plugged into a suitable female receptacle, not shown. The top portion 17 is adapted to be connected by solder or the like, not shown, to one of the aforementioned circuit lands, not shown, on surface 13. The circuit lines are arranged or configured in a fan out array that originates from the bonding pads located at the chip bonding site at the center of the substrate 11 and that terminates in the circuit lands located at the periphery of the substrate adjacent the pins 15 in a manner well known to those familiar with the art.

As shown in greater detail in Fig. 1B, in accordance with the principles of the present invention, each center portion 16 has an extension 19 in interlocking engaged relationship with the ceramic particles within the region 20 of the substrate 11 immediately surrounding the opening 12 that is associated with the particular portion 16. It should be noted that the extension 19 provides a substantially conformal jig saw puzzle-like fit with the substrate 11 as shown in Fig. 1B. For sake of clarity, the extension 19 is indicated schematically as a heavy solid line in Fig. 1A and is omitted in Fig. 1.

To form the extension 19 and provide the aforementioned interlocking engaged relationship, each member 15 is initially inserted into one of the slightly larger preformed openings 12 of the cured substrate 11. After insertion, the member 15 is impacted with a predetermined force that causes it temporarily to change from a solid to a fluid state. While the exact theory of operation is not known, it is believed that the impact places member 15 in a temporary viscoelastic fluid state. As a result, some of the fluid flows and penetrates between and without damage to the ceramic particles within the surrounding substrate region 20 of opening 12. Hence, when member 15 returns to its undisturbed solid state, the once fluid material of member 15 which penetrated between the ceramic particles remains entrapped therebetween and upon solidifying forms the extension 19 which is integral with the core 16C, Fig. 1B, of the intermediate portion 16. As such, the extension 19, and hence member 15, is in interlocking engagement with the ceramic particles, thereby providing an improved mechanical interconnection of member 15 to substrate 11, as well as resulting in an improved fill of the opening 12.

By way of information, the term viscoelastic, as is well known to those familiar with the art, relates to the mechanical behavior of a material which exhibits viscous and delayed response to stress in addition to instantaneous elasticity. Such properties are considered associated with rate effects, cf. Van Nostrand's Scientific Encyclopedia, published by D. Van Nostrand Inc., 1968, page 1942. Others have studied the impact of a rigid mass on a viscoelastic medium, cf., for example, the publication entitled "Mass Impact On Viscoelastic Bodies", A. H. Landzberg, International Business Machines Corporation Research Center, Yorktown Heights, N.Y., Research Report No. RC—140, October 5, 1959. Thus as used herein, the term viscoelastic fluid is used to describe the temporary condition or state into which a body is transformed when impacted by an appropriate impact force.

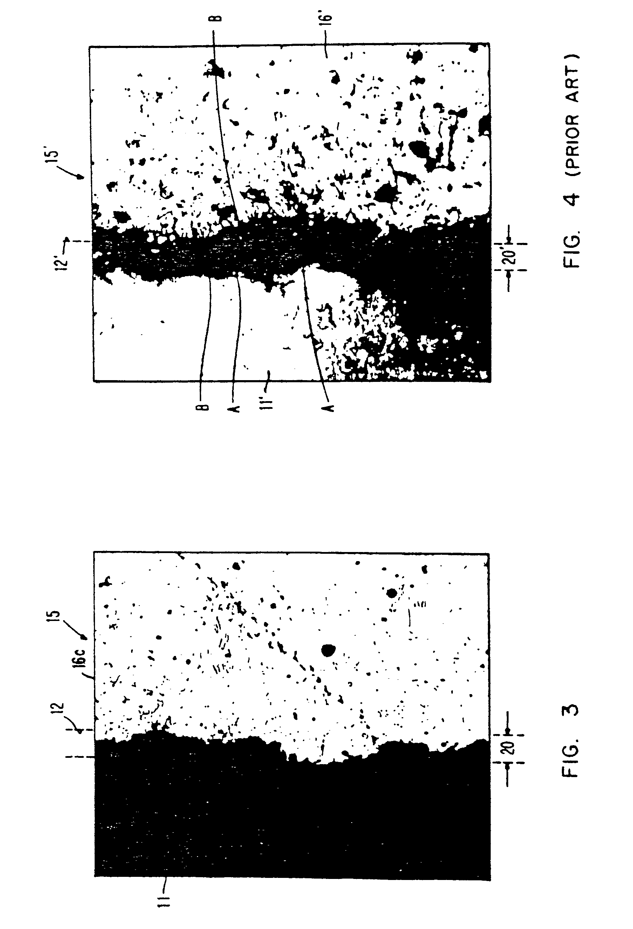

To help better understand and demonstrate the principles of the present invention, there is shown in Fig. 3 a highly magnified, i.e. 400X, photomicrograph of a portion of a cross-sectional test specimen taken from a substrate that was pinned using an impact force to form an extension in the manner previously described. As such, the photomicrograph of Fig. 3 shows a portion of the so formed extension 19. It should be noted that the extension 19, Fig. 3, is in interlocking engagement with the ceramic particles of region 20 of substrate 11 that surrounds the hole 12, and that the extension 19, is integral with the core 16C of the pin's portion 16 within the hole 12. The photomicrograph of Fig. 3 also illustrates the improved hole fill and/or conformal fitting of the extension 19 with the adjacent ceramic particles of the substrate 11.

By way of comparison, there is shown in Fig. 4 a photomicrograph of substantially equal magnification, i.e., 400X, of a portion of a cross-sectional test specimen taken from a substrate that was pinned using a conventional head and bulge system of the prior art, the pin, hole and substrate of Fig. 4 being of substantially comparable sizes and materials as those used for the apparatus of Fig. 3. As it is apparent from Fig. 4, the portion 16' of pin 15' does not have an extension within a comparable size region 20' of substrate 11' that surrounds the hole 12'. Moreover, the ceramic substrate 11' shows evidence of cracking as indicated by the reference characters A, and voids or spaces as indicated by the reference characters B, between the portion 16' of pin 15' and the substrate 11' in the hole 12'. As a result, the apparatus of Fig. 4, has poor hole fill and/or the absence of conformal fitting.

Referring now to Fig. 2, there is shown a machine 30 for making pinned ceramic substrate apparatus of the present invention. It includes a cylindrical anvil head 31 which is concentric with the centre axis 32 of machine 30. The head 31 is part of a demountable assembly which includes the lower cylindrical stem 33, that is axially slidable in an appropriate bore 34A in the lower leg 34L of U-shaped frame 34. The head 31 and stem 33 assembly are biased in an upright position by the compression spring 35 that is disposed about the stem 33 between the undersurface of the head 31 and inner face of the lower leg 34L.

Head 31 is concentrically aligned with a cylindrical, rigid mass hammer 36 which is adapted to axially slide in concentric hollow cylindrical guide 37. Guide 37 is affixed in a bore 34B provided in the upper leg 34U of frame 34. Guide 37 extends through bore 34B such that its lower open end, shown partially broken away for purposes of explanation, is in contact with the upper face of the upwardly biased head 31 in the absence of a ceramic substrate thereon. A slide trigger 38 engages the hammer 36 through an opening, not shown, in the guide 37 to retain the hammer 36 in the illustrated upright position and maintains the elastic band 39 in tension around the upper leg 34U of frame 34 and the V-shaped groove 40 formed in the upper end of hammer 36. It should be understood that the members 31, 33, 36, 37 are in substantially concentric alignment with the axis 32.

In operation, when a cured ceramic substrate is to be pinned, the assembly 31/33 is first depressed downwardly towards the inner face of leg 34L so as to provide access to the upper surface of anvil head 31. While the assembly is in this position, a cured substrate 110 is placed on the anvil head upper surface and a pin 150 inserted in the preformed substrate hole 120. The pin 150 is inserted into the hole 120 such that it protrudes above the upper substrate surface 130. It should be understood that there is a correspondingly aligned partial bore, not shown, in the anvil head 31 to receive the longer extended portion, not shown, of the pin 150 which protrudes outwardly from the lower end of the hole 120. The substrate 110 is positioned on the anvil head 31 such that, when the assembly 31/33 returns to its upwardly biased position, the substrate 110 is held firmly in position between the head 31 and the lower end of the hollow guide 37, and such that the top of pin 150 is within the guide 37 and in substantial concentric alignment with the guide 37 and hammer 36.

To pin, i.e., affix the pin 150 to the substrate 110, the trigger 38 is withdrawn from the guide 37, and the hammer 36 is propelled downward by the contracting elastic band 39. By judiciously selecting the elastic band tension, hammer mass, hammer travel or stroke, and spring parameters, the pin 150 is impacted by the hammer 36 with an appropriate impact force that produces an extension, not shown, but similar to the extension 19 of the pin 15 of Figs. 1, 1A, 1B and which extension is in interlocking engagement with the ceramic particles of the substrate 110 in a region that surrounds the hole 120.

In the preferred embodiment, the invention is practiced with a metallic member 15 that has an elongated configuration and circular cross-sectional configuration, is made of copper, and is being used as an electrical connector; and with a substrate 11 which is entirely ceramic, which has openings 12 with circular cross-sections that pass entirely through the substrate, and which has a single metallization layer. As is apparent to those skilled in the art, the metallic member may have other longitudinal and/or cross-sectional configurations, be made of other suitable metallic materials, and/or be used for other purposes. Thus, for example, the metallic members may be configured as short interconnecting pins for electrically interconnecting two metallization layers, i.e. planes of a substrate, or in the case of an elongated pin it may be used as a mechanical standoff leg. Likewise, the substrate need only be made of ceramic in those regions surrounding the openings, and/or the substrate may have no or two or more metallization layers; and/or the openings may have other cross-sectional configurations compatible with those of the metallic members and/or need only pass partially into the substrate.

Moreover, it should be understood, that substrates of the present invention can be pinned relying exclusively on the aforementioned interlocking engaged relationship between the extension and ceramic particles, or alternatively may be combined with other pinned relationships such as, for example, the head and/or bulge formations 21 and 22, respectively, shown in phantom outline form in Fig. 1.

**Claims**

1. A pinned substrate (10) comprising a substrate (11) having at least one opening (12) with a surrounding region thereof consisting of ceramic particles at least within said region, and at least one

metallic member (15) having at least a portion (16) thereof located in said opening, characterized by said portion having an extension (19) in interlocking engaged relationship with said ceramic particles of said region, said extension being formed by placing said metallic member in a temporary viscoelastic fluid state causing a partial flow thereof between said ceramic particles.

2. The pinned substrate according to claim 1, wherin said substrate (11) is a planar member with first and second opposite surfaces (13, 14), said opening (12) extending completely through said member between said surfaces.

3. The pinned substrate according to claim 2, wherein said metallic member is an elongated pin (15) located in said opening (12) and extending outwardly from said opening past said first and second surfaces (13, 14).

4. The pinned substrate according to claim 3, wherein said pin (15) is of the pluggable type.

5. Method for affixing a metallic member (15) to a ceramic substrate (11), comprising the step of placing a portion (16) of said member into an opening (12) of said substrate, characterized by impacting said member with a predetermined impact force that places said member in a temporary viscoelastic fluid state, thus causing a partial flow of said member between the ceramic particles of said substrate.

6. The method of claim 5, wherein said ceramic substrate (11) has a planar configuration with first and second opposite surfaces (13, 14), wherein said opening (12) extends between said surfaces and is slightly larger than said metallic member (15), and wherein said metallic member is placed such that it extends outwardly from said opening past said first and second surfaces.

## Patentansprüche

1. Mit Anschlußstiften versehenes Substrat (10) mit einem Substrat (11), das mindestens eine Öffnung (12) aufweist, deren umgebender Bereich zumindest aus Keramikteilchen besteht, sowie mindestens einem Metallteil (15), von dem wenigstens ein Stück (16) in der Öffnung angeordnet ist,

dadurch gekennzeichnet, daß dieses Stück eine Verlängerung (19) aufweist, die mit den Keramikteilchen des umgebenden Bereiches in Verbindung steht, wobei die Verlängerung dadurch gebildet wird, daß das Metallteil vorübergehend in einem viskoelastischen flüssigen Zustand versetzt wird und dadurch teilweise zwischen die Keramikteilchen gelangt.

2. Substrat gemäß Anspruch 1, dadurch gekennzeichnet, daß das Substrat (11) als ebenes, eine erste and eine zweite gegenüberliegende Fläche (13, 14) aufweisendes Teil ausgebildet ist, und die Öffnung (12) durch das gesamte Substrat zwischen dessen beiden Flächen verläuft.

3. Substrat gemäß Anspruch 2, dadurch gekennzeichnet, daß das Metallteil als verlängerter Stift (15) ausgebildet ist, der sich in der Öffnung (12) befindet und sich von dieser Öffnung nach außen über die erste und zweite Fläche (13, 14) erstreckt.

4. Substrat gemäß Anspruch 3, dadurch gekennzeichnet, daß der Stift (15) ein Anschlußstift ist.

5. Verfahren zum Befestigen eines Metallteiles (15) an einem Keramiksubstrat (11), das folgenden Schritt umfaßt: Anordnung eines Stücks (16) des Metallteils in einer Öffnung (12) des Substrat, dadurch gekennzeichnet, daß das Metallteil mit einer Kraft beaufschlagt wird, die es vorübergehend in einen viskoelastischen flüssigen Zustand versetzt und dadurch zwischen die Keramikteilchen gelangen läßt.

6. Verfahren gemäß Anspruch 5, dadurch gekennzeichnet, daß das Keramiksubstrat (11) als ebenes, eine erste und zweite gegenüberliegende Fläche (13, 14) aufweisendes Teil ausgebildet ist, wobei die Öffnung (12) zwischen den Flächen angeordnet und etwas größer als das Metallteil (15) ist, und das Metallteil so angeordnet ist, daß es sich von der Öffnung nach außen über die erste und zweite Fläche erstreckt.

## Revendications

1. Un substrat muni de broches (10) comprenant un substrat (11) comportant au moins une ouverture (12) et contenant des particules céramiques au moins à l'intérieur de la zone entourant ladite ouverture, et au moins un élément métallique (15) dont au moins une partie (16) est placée dans ladite ouverture, caractérisé en ce que ladite partie comporte un élargissement (19) en relation d'accrochage mutuel avec lesdites particules céramiques de ladite zone, ledit élargissement étant formé en plaçant ledit élément métallique dans un état fluide viscoélastique temporaire produisant son fluage partiel entre lesdites particules céramiques.

2. Le substrat muni de broches selon la revendication 1, caractérisé en ce que ledit substrat (11) est un élément plan comportant des première et seconde surfaces opposées (13, 14), ladite ouverture (12) s'étendant complètement au travers dudit élément entre lesdites surfaces.

3. Le substrat muni de broches selon la revendication 2, caractérisé en ce que ledit élément métallique est une broche allongée (15) placée dans ladite ouverture (12) et dépassant extérieurement de ladite ouverture à partir desdites première et seconde surfaces (13, 14).

4. Le substrat muni de broches selon la revendication 3, caractérisé en ce que ladite broche (15) est du type enfichable.

5. Procédé pour fixer un élément métallique (15) dans un substrat céramique (11), comprenant l'étape consistant à placer une partie (16) dudit élément dans une ouverture (12) dudit substrat, caractérisé en ce que ledit élément est percuté avec une force d'impact prédéterminée qui place ledit élément dans un état fluide viscoélastique temporaire, en produisant ainsi un fluage partiel dudit élément entre les particules céramiques dudit substrat.

6. Le procédé selon la revendication 5, caractérisé en ce que ledit substrat céramique (11) a une configuration plane comportant des première et seconde surfaces opposées (13, 14), en ce que ladite ouverture (12) s'étend entre lesdites surfaces et est légèrement plus grande que ledit élément métallique (15) et en ce que ledit élément métallique est placé de telle sorte qu'il dépasse extérieurement de ladite ouverture à partir desdites première et seconde surfaces.

FIG. 1

FIG. 2

FIG. 1A

FIG. 1B

FIG. 4 (PRIOR ART)

FIG. 3

2